# EUROPEAN PATENT APPLICATION

(11) **EP 4 568 442 A1**
(43) Date of publication of application: **11.06.2025**
(21) Application number: 24213491.4
(22) Date of filing: 18.11.2024
(51) Int. Cl.: H10B 12/00, H10D 1/68

(54) **INTEGRATED CIRCUIT DEVICE AND METHOD OF MANUFACTURING THE SAME**

(30) Priority: 08.12.2023 KR 20230178047
(71) Applicant: Samsung Electronics Co., Ltd., Suwon-si, Gyeonggi-do 16677 (KR)
(72) Inventor: PARK, Jungmin, 16677 Suwon-si (KR); KIM, Taekyun, 16677 Suwon-si (KR); LIM, Jaesoon, 16677 Suwon-si (KR); JUNG, Hyungsuk, 16677 Suwon-si (KR); KIM, Beomjong, 16677 Suwon-si (KR)
(74) Representative: Marks & Clerk LLP

(57) **Abstract**

Provided is an integrated circuit device and method of manufacturing same, the integrated circuit device including: a substrate including a memory cell area and a peripheral circuit area around the memory cell area; a cell transistor in the memory cell area; a peripheral circuit transistor in the peripheral circuit area; a capacitor structure including a lower electrode on the cell transistor, a dielectric film on a surface of the lower electrode, and an upper electrode on the dielectric film; a stacked plate structure covering the capacitor structure; and an interlayer insulating film covering the stacked plate structure in the memory cell area and covering the peripheral circuit transistor in the peripheral circuit area, wherein the stacked plate structure includes: a first plate layer including doped silicon germanium (SiGe); a middle layer conformally covering the first plate layer, the middle layer including a metal silicide (MₓSi_{y}) including a metal (M) or the middle layer including a metal silicon nitride (MₓSi_{y}N) including a metal (M); and a second plate layer conformally covering the middle layer and including the metal (M) included in the middle layer.

## Description

### BACKGROUND

### 1. Field

The disclosure relates to an integrated circuit device, and more particularly, to an integrated circuit device including a capacitor and a method of manufacturing the integrated circuit device.

### 2. Description of Related Art

With the rapid development of miniaturized semiconductor processing technology, the areas of unit cells have reduced as the high integration of integrated circuit devices is accelerated. Accordingly, the area that a capacitor may occupy within a unit cell has also reduced. For example, as the integration degree of an integrated circuit device, such as dynamic random access memory (DRAM), has increased, the area of a unit cell is reduced, and in contrast, the required capacitance thereof is maintained or increased. Accordingly, a structure that may overcome spatial limitations and design rule limitations in a capacitor, improve capacitance, and maintain desired electrical characteristics is needed.

### SUMMARY

Provided is an integrated circuit device with improved electrical characteristics and product reliability using a stacked plate structure in which a middle layer is inserted between a doped silicon germanium layer and a tungsten plate layer in dynamic random access memory (DRAM) including the stacked plate structure in a capacitor structure.

Further provided is a method of manufacturing an integrated circuit device with improved electrical characteristics and product reliability using a stacked plate structure that inserts a middle layer between a doped silicon germanium layer and a tungsten plate layer in dynamic random access memory (DRAM) including the stacked plate structure in a capacitor structure.

According to an aspect of the disclosure, an integrated circuit device includes: a substrate including a memory cell area and a peripheral circuit area around the memory cell area; a cell transistor in the memory cell area; a peripheral circuit transistor in the peripheral circuit area; a capacitor structure including a lower electrode on the cell transistor, a dielectric film on a surface of the lower electrode, and an upper electrode on the dielectric film; a stacked plate structure covering the capacitor structure; and an interlayer insulating film covering the stacked plate structure in the memory cell area and covering the peripheral circuit transistor in the peripheral circuit area, wherein the stacked plate structure includes: a first plate layer including doped silicon germanium (SiGe); a middle layer conformally covering the first plate layer and including a metal silicide (MₓSi_{y}) including a metal (M); and a second plate layer conformally covering the middle layer and including the metal (M) of the metal silicide.

According to an aspect of the disclosure, an integrated circuit device includes: a substrate including a memory cell area and a peripheral circuit area around the memory cell area; a cell transistor in the memory cell area; a peripheral circuit transistor in the peripheral circuit area; a capacitor structure including a lower electrode on the cell transistor, a dielectric film on a surface of the lower electrode, and an upper electrode on the dielectric film; a stacked plate structure covering the capacitor structure; and an interlayer insulating film covering the stacked plate structure in the memory cell area and covering the peripheral circuit transistor in the peripheral circuit area, wherein the stacked plate structure includes: a first plate layer including doped silicon germanium (SiGe); a second plate layer including a metal (M); and a first middle layer including a metal silicide (MₓSi_{y}) and a second middle layer including a metal silicon nitride (MₓSi_{y}N), wherein the first middle layer and the second middle layer are between the first plate layer and the second plate layer.

According to an aspect of the disclosure, an integrated circuit device includes: a cell transistor in a memory cell area of the integrated circuit device; a capacitor structure including a lower electrode on the cell transistor, a dielectric film on a surface of the lower electrode, and an upper electrode on the dielectric film; a stacked plate structure covering the capacitor structure; an interlayer insulating film covering the stacked plate structure; and a metal contact connected to the stacked plate structure and penetrating the interlayer insulating film, wherein the stacked plate structure includes: a first plate layer including doped silicon germanium (SiGe); a middle layer conformally covering the first plate layer and including one selected from tungsten silicide (WSiₓ) and tungsten silicon nitride (WSiₓN_{y}); and a second plate layer conformally covering the middle layer and including tungsten (W).

Objectives of the disclosure are not limited to those mentioned above, and other objectives not mentioned above will be clearly understood by those skilled in the art from the description below.

At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a layout diagram illustrating an integrated circuit device according to an embodiment;
FIG. 2 is an enlarged view of portion A1 of FIG. 1;
FIG. 3 is a cross-sectional view of the integrated circuit device of FIG. 2 taken along line B1-B1';
FIG. 4 is an enlarged view of portion CX1 of FIG. 3;
FIG. 5 is a cross-sectional view illustrating an integrated circuit device according to an embodiment;
FIG. 6 is an enlarged view of portion CX2 of FIG. 5;
FIG. 7 is a layout diagram illustrating an integrated circuit device according to an embodiment;
FIG. 8 is a cross-sectional view of the integrated circuit device of FIG. 7 taken along line C1-C1';
FIG. 9 is a flowchart illustrating a method of manufacturing an integrated circuit device, according to an embodiment;
FIGS. 10, 11, 12, 13, 14, 15, 16, 17, 18 and 19 are cross-sectional views illustrating a method of manufacturing an integrated circuit device, according to an embodiment; and
FIG. 20 is a configuration diagram illustrating a system including an integrated circuit device according to an embodiment.

### DETAILED DESCRIPTION

Hereinafter, embodiments of the disclosure are described in detail with reference to the attached drawings.

In the following description, like reference numerals refer to like elements throughout the specification. As used herein, a plurality of "units", "modules", "members", and "blocks" may be implemented as a single component, or a single "unit", "module", "member", and "block" may include a plurality of components.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

Herein, the expressions "at least one of a, b or c" and "at least one of a, b and c" indicate "only a," "only b," "only c," "both a and b," "both a and c," "both b and c," and "all of a, b, and c."

It will be understood that, although the terms first, second, third, etc., may be used herein to describe various elements, is the disclosure should not be limited by these terms. These terms are only used to distinguish one element from another element.

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

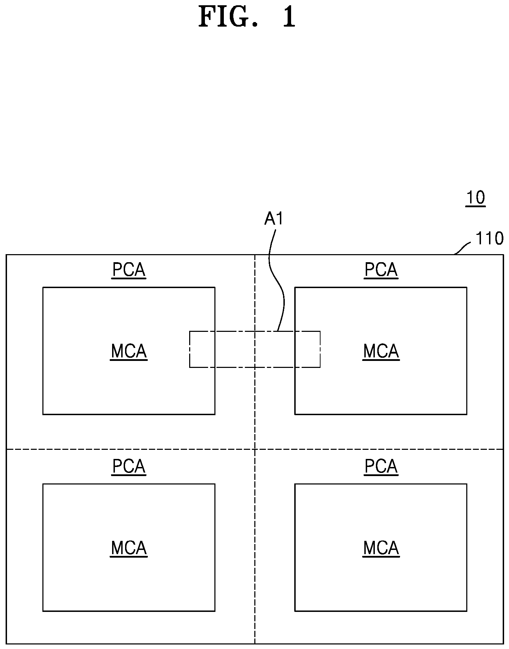

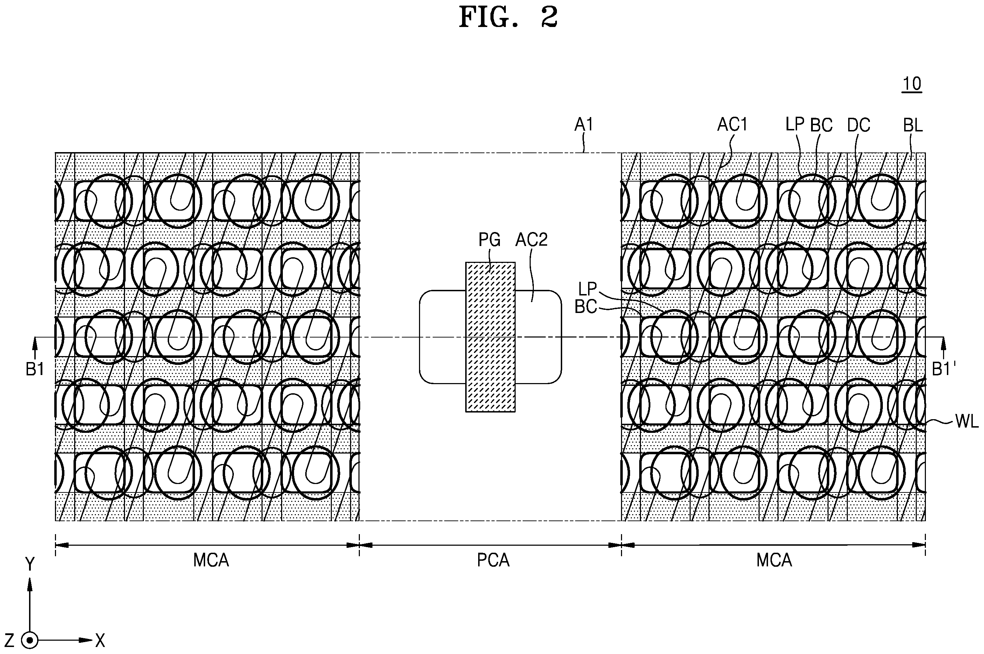

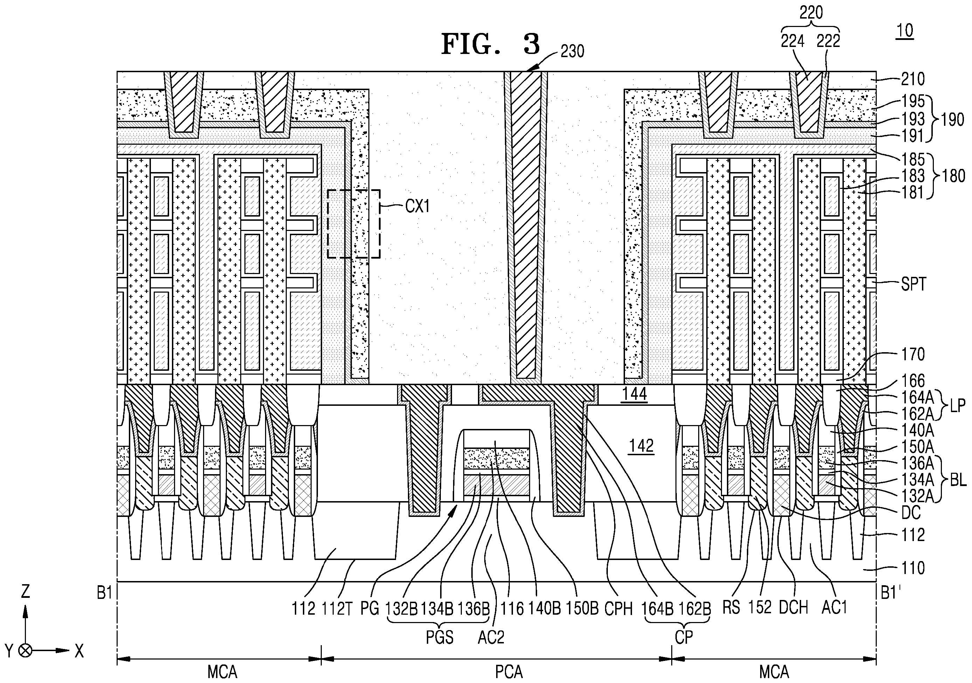

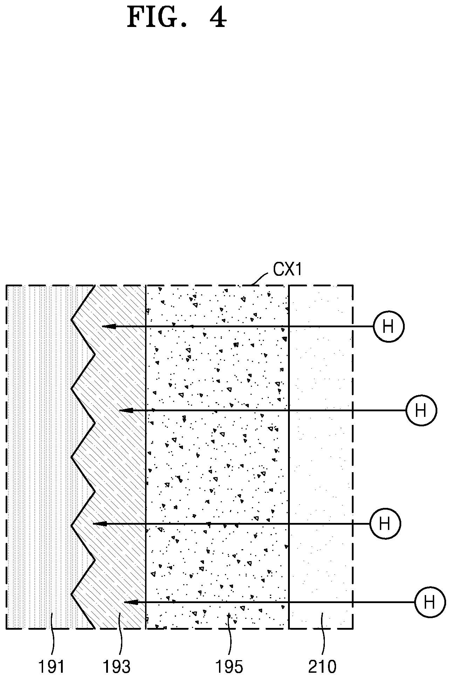

FIG. 1 is a layout diagram illustrating an integrated circuit device, FIG. 2 is an enlarged view of portion A1 of FIG. 1, FIG. 3 is a cross-sectional view of the integrated circuit device of FIG. 2 taken along line B 1-B 1', and FIG. 4 is an enlarged view of portion CX1 of FIG. 3.

Referring to FIGS. 1 to 4 together, an integrated circuit device 10 may include a substrate 110 including a memory cell area MCA and a peripheral circuit area PCA.

The memory cell area MCA may be an array area of volatile memory cells of a dynamic random access memory (DRAM) device, and the peripheral circuit area PCA may be a core area or a peripheral circuit area of the DRAM device. For example, the peripheral circuit area PCA may include a peripheral circuit transistor PG for transferring signals and/or power to a memory cell array included in the memory cell area MCA.

In one or more embodiments, the peripheral circuit transistor PG may form part of various circuits, such as a command decoder, a control logic, an address buffer, a row decoder, a column decoder, a sense amplifier, a data input/output circuit, or the like.

A device isolation trench 112T may be formed in the substrate 110, and a device isolation film 112 may be formed within the device isolation trench 112T. The device isolation film 112 may include silicon oxide, silicon nitride, or a combination thereof. Through the device isolation film 112, a plurality of first active areas AC1 may be defined in the substrate 110 in the memory cell area MCA, and a second active area AC2 may be defined in the substrate 110 in the peripheral circuit area PCA.

In the memory cell area MCA, each of the plurality of first active areas AC1 may be arranged to have a major axis in a diagonal direction with respect to a first horizontal direction X and a second horizontal direction Y. A plurality of word lines WL may cross the plurality of first active areas AC1 and extend parallel to each other in the first horizontal direction X. A plurality of bit lines BL may extend on the plurality of word lines WL to be parallel to each other in the second horizontal direction Y. The plurality of bit lines BL may be connected to the plurality of first active areas AC1 through a plurality of direct contacts DC.

A plurality of barrier contacts BC may be formed between two neighboring bit lines BL among the plurality of bit lines BL. The plurality of barrier contacts BC may be arranged in a row in the first horizontal direction X and the second horizontal direction Y. A plurality of landing pads LP may be formed on the plurality of barrier contacts BC. The plurality of barrier contacts BC and the plurality of landing pads LP may connect a lower electrode 181 of a capacitor structure 180 formed on the plurality of bit lines BL to a first active area AC1. Each of the plurality of landing pads LP may be arranged such that a portion thereof overlaps a barrier contact BC in a vertical direction Z.

The substrate 110 may be a wafer including silicon (Si). In one or more embodiments, the substrate 110 may be a wafer including a semiconductor element, such as germanium (Ge), or a compound semiconductor, such as silicon carbide (SiC), gallium arsenide (GaAs), indium arsenide (InAs), and indium phosphide (InP). The substrate 110 may have a silicon-on-insulator (SOI) structure. In addition, the substrate 110 may include a conductive area, for example a well doped with impurities or a structure doped with impurities.

The plurality of direct contacts DC may be formed within a plurality of direct contact holes DCH of the substrate 110. The plurality of direct contacts DC may be connected to the plurality of first active areas AC1. Each of the plurality of direct contacts DC may include doped polysilicon. For example, each of the plurality of direct contacts DC may include polysilicon containing a relatively high concentration of impurities such as phosphorus (P), arsenic (As), bismuth (Bi), and antimony (Sb).

The plurality of bit lines BL may extend lengthwise on the substrate 110 and the plurality of direct contacts DC in the second horizontal direction Y. Each of the plurality of bit lines BL may be connected to the first active area AC1 through a direct contact DC. Each of the plurality of bit lines BL may include a lower conductive pattern 132A, a middle conductive pattern 134A, and an upper conductive pattern 136A, which are sequentially stacked on the substrate 110. The lower conductive pattern 132A may include doped polysilicon. As shown in Figure 3, in the regions where the plurality of direct contacts DC are formed, the lower conductive pattern 132A of a bit line and a direct contact may be formed as a single pattern. Alternatively, the lower conductive pattern 132A may be formed as a separate layer on top of the direct contact DC. Each of the middle conductive pattern 134A and the upper conductive pattern 136A may include TiN, TiSiN, W, tungsten silicide, or a combination thereof. In one or more embodiments, the middle conductive pattern 134A may include TiN, TiSiN, or a combination thereof, and the upper conductive pattern 136A may include tungsten.

The plurality of bit lines BL may be covered with a plurality of capping layers 140A. The plurality of capping layers 140A may extend on the plurality of bit lines BL in the second horizontal direction Y. Spacers 150A may be arranged on both sidewalls of each of the plurality of bit lines BL. The spacers 150A may extend on both sidewalls of each of the plurality of bit lines BL in the second horizontal direction Y, and a portion of each of the spacers 150A may extend to the inside of a direct contact hole DCH to cover each of both sidewalls of the direct contact DC.

The direct contact DC may be formed within the direct contact hole DCH formed in the substrate 110 and extend to a level higher than the upper surface of the substrate 110. For example, the upper surface of the direct contact DC may be arranged at the same level as the upper surface of the lower conductive pattern 132A, and the upper surface of the direct contact DC may be in contact with the bottom surface of the middle conductive pattern 134A. In addition, the bottom surface of the direct contact DC may be arranged at a level lower than the upper surface of the substrate 110.

A plurality of insulating fences and a plurality of conductive plugs 152 may be arranged in a row between the plurality of bit lines BL in the second horizontal direction Y. The plurality of conductive plugs 152 may extend lengthwise in the vertical direction Z from a recess space RS formed in the substrate 110. Both sidewalls of each of the plurality of conductive plugs 152 in the second horizontal direction Y may be insulated from each other by the plurality of insulating fences. The plurality of conductive plugs 152 may form the plurality of barrier contacts BC.

The plurality of landing pads LP may be formed above the plurality of conductive plugs 152. A metal silicide film may be further arranged between the plurality of conductive plugs 152 and the plurality of landing pads LP. The metal silicide film may include cobalt silicide, nickel silicide, or manganese silicide. Each of the plurality of landing pads LP may include a conductive barrier film 162A and a landing pad conductive layer 164A. The conductive barrier film 162A may include Ti, TiN, or a combination thereof. The landing pad conductive layer 164A may include metal, metal nitride, conductive polysilicon, or a combination thereof. Each of the plurality of landing pads LP may have an island-type shape in a plan view. The plurality of landing pads LP may be electrically insulated from each other by an insulating pattern 166 surrounding the plurality of landing pads LP.

In the peripheral circuit area PCA, the peripheral circuit transistor PG may be arranged in the second active area AC2. The peripheral circuit transistor PG may include a gate dielectric film 116, a gate electrode PGS, and a gate capping pattern 140B, which are sequentially stacked in the second active area AC2. In the second active area AC2 the substrate 110 is doped to form source and drain regions separated by a channel region, the channel region arranged below the gate electrode PGS.

The gate dielectric film 116 may include at least one selected from silicon oxide, silicon nitride, silicon oxynitride, and a high dielectric material having a higher dielectric constant than silicon oxide. The gate electrode PGS may include a lower conductive pattern 132B, a middle conductive pattern 134B, and an upper conductive pattern 136B. The constituent materials of the lower conductive pattern 132B, the middle conductive pattern 134B, and the upper conductive pattern 136B may be the same as the constituent materials of the lower conductive pattern 132A, the middle conductive pattern 134A, and the upper conductive pattern 136A included in a bit line BL in the memory cell area MCA, respectively. In addition, the gate capping pattern 140B may include silicon nitride.

In one or more embodiments, both sidewalls of the gate electrode PGS may be covered with gate spacers 150B. Each of gate spacers 150B may include silicon oxide, silicon nitride, or a combination thereof.

The peripheral circuit transistor PG may be covered with a first insulating film 142. A second insulating film 144 may be arranged on the first insulating film 142. In the peripheral circuit area PCA, a contact plug CP may be formed in a contact hole CPH that vertically penetrates the first insulating film 142 and the second insulating film 144. The contact plug CP may include a conductive barrier film 162B and a landing pad conductive layer 164B, similar to the plurality of landing pads LP formed in the memory cell area MCA.

In the memory cell area MCA, an upper insulating pattern 170 may be arranged on the insulating pattern 166. The upper insulating pattern 170 may include a material having an etch selectivity with respect to the second insulating film 144 and the insulating pattern 166. For example, the upper insulating pattern 170 may include silicon nitride.

In the memory cell area MCA, the capacitor structure 180 may be arranged on the upper insulating pattern 170. The capacitor structure 180 may include a plurality of lower electrodes 181, a capacitor dielectric film 183, and an upper electrode 185.

The plurality of lower electrodes 181 may extend on the plurality of landing pads LP in the vertical direction Z. The bottom portions of the plurality of lower electrodes 181 may be arranged within an opening portion of the upper insulating pattern 170. A support layer SPT may be arranged on the sidewalls the plurality of lower electrodes 181. The support layer SPT may maintain a constant distance between two neighboring lower electrodes 181 and prevent the plurality of lower electrodes 181 from tilting or falling. A plurality of support layers SPT may be formed on the sidewalls of the plurality of lower electrodes 181 at different levels in the vertical direction Z.

The capacitor dielectric film 183 may be arranged on the plurality of lower electrodes 181. The capacitor dielectric film 183 may extend from the sidewalls of the plurality of lower electrodes 181 to the upper surface and the bottom surface of the support layer SPT and may extend onto the upper insulating pattern 170.

The upper electrode 185 may be arranged on the capacitor dielectric film 183. The upper electrode 185 may be arranged to entirely cover the capacitor dielectric film 183 and may cover the plurality of lower electrodes 181 with the capacitor dielectric film 183 therebetween.

In one or more embodiments, each of the plurality of lower electrodes 181 and the upper electrode 185 may include at least one selected from a metal, such as ruthenium (Ru), titanium (Ti), tantalum (Ta), niobium (Nb), iridium (Ir), molybdenum (Mo), and tungsten (W), a conductive metal nitride, such as titanium nitride (TiN), tantalum nitride (TaN), niobium nitride (NbN), molybdenum nitride (MoN), and tungsten nitride (WN), and a conductive metal oxide, such as iridium oxide (IrO₂), ruthenium oxide (RuO₂), and strontium ruthenium oxide (SrRuO₃).

In one or more embodiments, the capacitor dielectric film 183 may include at least one of zirconium oxide, hafnium oxide, titanium oxide, niobium oxide, tantalum oxide, yttrium oxide, strontium titanium oxide, barium strontium titanium oxide, scandium oxide, and lanthanide oxide.

The capacitor structure 180 may be formed only in the memory cell area MCA. That is, the capacitor structure 180 may not be formed in the peripheral circuit area PCA.

In the integrated circuit device 10 of the disclosure, a stacked plate structure 190 may be arranged along the surface of the capacitor structure 180 having the above shape. Due to a large step-difference between the memory cell area MCA and the peripheral circuit area PCA, the surface of the stacked plate structure 190 may include a flat upper surface and a vertical sidewall.

The stacked plate structure 190 may include a first plate layer 191, a middle layer 193 conformally covering the first plate layer 191, and a second plate layer 195 conformally covering the middle layer 193.

The first plate layer 191 may include a doped semiconductor material. In one or more embodiments, the first plate layer 191 may include silicon germanium (SiGe) doped with a p-type impurity. Herein, the p-type impurity may be, for example, boron (B), gallium (Ga), indium (In), or the like. In addition, the first plate layer 191 may be in a crystalline state. The thickness of the first plate layer 191 may be about 800 Å to about 2,000 Å, but is not limited thereto.

The middle layer 193 may include metal silicide (MₓSi_{y}) or metal silicon nitride (MₓSi_{y}N_{z}). That is, the middle layer 193 may include any one selected from metal silicide (MₓSi_{y}) and metal silicon nitride (MₓSi_{y}N_{z}). In one or more embodiments, the metal (M) may be tungsten (W). In this case, the middle layer 193 may include one selected from tungsten silicide (WSiₓ) and tungsten silicon nitride (WSiₓN_{y}), but is not limited thereto.

The middle layer 193 may be in an amorphous state, or the middle layer 193 may be configured to have an amorphous state in most (over 50 %) of the areas thereof and a crystallized state only in local areas thereof. That is, the dominant crystal structure of the middle layer 193 may be an amorphous structure. The thickness of the middle layer 193 may be about 50 Å to about 200 Å, but is not limited thereto.

In addition, in the metal silicide (MₓSi_{y}) or metal silicon nitride (MₓSi_{y}N_{z}) that is included in the middle layer 193, the concentration of silicon (Si) may be about 1 wt% to about 20 wt%. That is, by adjusting the concentration of silicon (Si), the sheet resistance of the middle layer 193 may be configured to satisfy about 1 ohm to about 100 ohms, and the work function of the middle layer 193 may be configured to satisfy about 4.4 eV to about 4.8 eV. However, the physical properties of the middle layer 193 are not limited to the above values.

The second plate layer 195 may have a plate shape made of the metal (M) included in the middle layer 193. In one or more embodiments, the metal (M) may be tungsten (W). In addition, the second plate layer 195 may be in a crystalline state. The thickness of the second plate layer 195 may be about 100 Å to about 1,000 Å, but is not limited thereto.

In the integrated circuit device 10 of the disclosure, the shape of the stacked plate structure 190 is described in detail as follows.

In one or more embodiments, the surface roughness of the first plate layer 191 at a surface in contact with the middle layer 193 may be greater than the surface roughness of the second plate layer 195 at a surface in contact with the middle layer 193 (see, e.g., FIG. 4 showing area CX1). That is, the middle layer 193 may be formed to fill the relatively rough surface of the first plate layer 191, so that the surface of the second plate layer 195 may be formed to be relatively smooth. Such a characteristic may be due to the fact that the middle layer 193 is in an amorphous state, and the middle layer 193 includes a material including both silicon (Si) included in the first plate layer 191 and the metal (M) included in the second plate layer 195.

In one or more embodiments, the sidewall of the first plate layer 191 may be completely covered with the middle layer 193, and most of the sidewall of the middle layer 193 may be in contact with the second plate layer 195, but a portion of the lower area of the sidewall of the middle layer 193 may be in contact with an interlayer insulating film 210 to be described below. Such a characteristic may be due to a manufacturing process in which a portion of the middle layer 193 and a portion of the second plate layer 195 are dry-etched together.

In one or more embodiments, the thickness in the vertical direction Z of the portion of the second plate layer 195 formed on the upper surface of the middle layer 193, may be greater than the width in the first horizontal direction X of the portion of the second plate layer 195 in the first horizontal direction X formed on the sidewall of the middle layer 193. Such a characteristic may be due to that the formation method of the second plate layer 195 is a physical vapor deposition (PVD) process.

The interlayer insulating film 210 may be arranged to cover both the memory cell area MCA and the peripheral circuit area PCA. The interlayer insulating film 210 may have different thicknesses in the vertical direction Z in respective areas to cover a step-difference depending on the presence or absence of the capacitor structure 180 and the stacked plate structure 190 in the memory cell area MCA and the peripheral circuit area PCA.

In the memory cell area MCA, a plurality of metal contacts 220 penetrating the interlayer insulating film 210 and extending in the vertical direction Z may be arranged. Bottom portions of the plurality of metal contacts 220 may be electrically connected to the first plate layer 191 by being in contact with the first plate layer 191. That is, the bottom portions of the plurality of metal contacts 220 may be electrically connected to the upper electrode 185 of the capacitor structure 180 through the first plate layer 191. Each of the plurality of metal contacts 220 may include a conductive barrier film 222 and a contact conductive layer 224.

In one or more embodiments, the plurality of metal contacts 220 may sequentially penetrate the second plate layer 195 and the middle layer 193. In addition, the level of the lowermost surface of the plurality of metal contacts 220 may be arranged to be lower than the level of the uppermost surface of the first plate layer 191 and higher than the level of the uppermost surface of the upper electrode 185.

In the peripheral circuit area PCA, a peripheral circuit contact 230 penetrating the interlayer insulating film 210 and extending in the vertical direction Z may be arranged. The bottom portion of the peripheral circuit contact 230 may be in contact with a contact pad, which is an upper portion of the contact plug CP. That is, the peripheral circuit contact 230 may be electrically connected to the peripheral circuit transistor PG through the contact plug CP. The peripheral circuit contact 230 may include the conductive barrier film 222 and the contact conductive layer 224, similar to the plurality of metal contacts 220 formed in the memory cell area MCA.

In one or more embodiments, the level of the lowermost surface of the peripheral circuit contact 230 may be arranged to be substantially the same as the level of the lowermost surface of the first plate layer 191 and the level of the lowermost surface of the middle layer 193 and to be lower than the level of the lowermost surface of the second plate layer 195.

In devices similar to integrated circuit device 10, in order to secure the sensing margin in the capacitor structure 180, a doped silicon germanium (SiGe) layer and a tungsten (W) plate layer may have been formed and used together.

However, since a space between the doped silicon germanium (SiGe) layer and the tungsten (W) plate layer is a junction of heterogeneous materials, the interfacial resistance between the doped silicon germanium (SiGe) layer and the tungsten (W) plate layer is quite large. In addition, due to the surface roughness of the doped silicon germanium (SiGe) layer, the interface condition thereof is poor and the adhesion strength thereof is reduced, thereby introducing a potential point of tearing of the tungsten (W) plate layer. In addition, since the doped silicon germanium (SiGe) layer and the tungsten (W) plate layer are commonly both crystalline materials in prior designs, hydrogen (H) generated in a manufacturing process of the integrated circuit device might easily penetrate through a grain boundary, thereby causing defects in electrical characteristics of capacitor structures similar to capacitor structure 180.

The present disclosure addresses this issue by forming middle layer 193 to include one selected from tungsten silicide (WSiₓ) and tungsten silicon nitride (WSiₓN_{y}) inserted between the first plate layer 191 including doped silicon germanium (SiGe) and the second plate layer 195 including tungsten (W).

That is, the middle layer 193 according to an embodiment includes both silicon (Si) included in the first plate layer 191 and the metal (M) included in the second plate layer 195, and thus the middle layer 193 may serve as an adhesive layer between the first plate layer 191 and the second plate layer 195 and may also significantly reduce the interfacial resistance that occurs between heterogeneous materials.

In addition, most or all of the area of the middle layer 193 may include a material in an amorphous state, and the material in the amorphous state does not have grain boundaries; thus, a path through which hydrogen (H) may move may be blocked. That is, the middle layer 193 may serve as a hydrogen (H) barrier layer.

Ultimately, the integrated circuit device 10 according to an embodiment may have improved electrical characteristics and product reliability by using the stacked plate structure 190, in which the middle layer 193 is inserted between the first plate layer 191 of a doped silicon germanium (SiGe) layer and the second plate layer 195 of the tungsten (W) plate layer, in the DRAM including the stacked plate structure 190 on the capacitor structure 180.

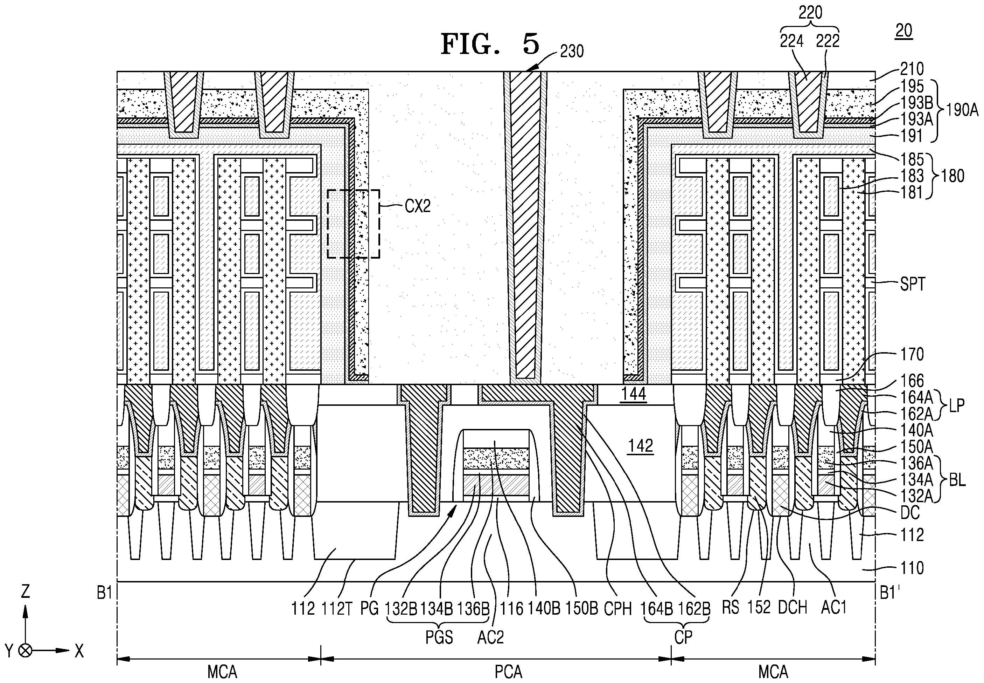

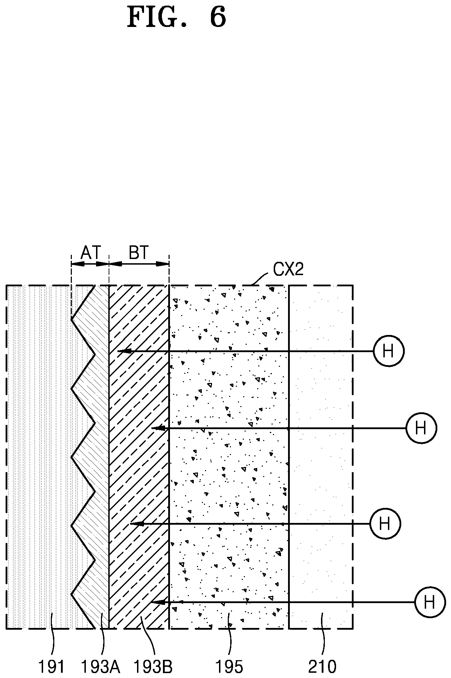

FIG. 5 is a cross-sectional view illustrating an integrated circuit device according to another embodiment, and FIG. 6 is an enlarged view of a portion CX2 of FIG. 5.

Hereinafter, most of the components constituting integrated circuit device 20 as described below, and the materials of the components of same, are substantially the same as or similar to those described above with reference to FIGS. 1 to 4. Accordingly, for convenience of explanation, the following description mainly focuses on differences between integrated circuit device 20 and integrated circuit device 10.

Referring to FIGS. 5 and 6 together, the integrated circuit device 20 may include the substrate 110 including the memory cell area MCA and the peripheral circuit area PCA.

In the integrated circuit device 20 of the disclosure, a stacked plate structure 190A may be arranged along the surface of the capacitor structure 180. Due to a large step-difference between the memory cell area MCA and the peripheral circuit area PCA, the surface of the stacked plate structure 190A may include a flat upper surface and a vertical sidewall.

The stacked plate structure 190A may include the first plate layer 191, a first middle layer 193A conformally covering the first plate layer 191, a second middle layer 193B conformally covering the first middle layer 193A, and the second plate layer 195 conformally covering the second middle layer 193B.

The first plate layer 191 may include p-type doped silicon germanium (SiGe). The thickness of the first plate layer 191 may be about 800 Å to about 2,000 Å, but is not limited thereto.

In one or more embodiments, the first middle layer 193A may include metal silicide (MₓSi_{y}), and the second middle layer 193B may include metal silicon nitride (MₓSi_{y}N_{z}). For example, the metal (M) may be tungsten (W). In this case, the first middle layer 193A may include tungsten silicide (WSiₓ), and the second middle layer 193B may include tungsten silicon nitride (WSiₓN_{y}), but the disclosure is not limited thereto.

Herein, a thickness AT of the first middle layer 193A may be less than a thickness BT of the second middle layer 193B. This is because the tungsten silicon nitride (WSiₓN_{y}) forming the second middle layer 193B may more effectively block the penetration of hydrogen (H) generated during a manufacturing process of the integrated circuit device 20. Accordingly, increasing the thickness BT of the second middle layer 193B may effectively improve the electrical characteristics of the integrated circuit device 20.

In another embodiment, the first middle layer 193A may include metal silicon nitride (MₓSi_{y}N_{z}), and the second middle layer 193B may include metal silicide (MₓSi_{y}). In this case, unlike the embodiment shown in FIG. 6, the thickness AT of the first middle layer 193A may be greater than the thickness BT of the second middle layer 193B. The reason is the same as explained above.

Each of the first middle layer 193A and the second middle layer 193B may be in an amorphous state, or the first middle layer 193A and the second middle layer 193B may be configured to have an amorphous state in most (over 50 %) of the areas thereof and a crystallized state only in local areas thereof. That is, the dominant crystal structure of each of the first middle layer 193A and the second middle layer 193B may be in an amorphous state.

In addition, in the metal silicide (MₓSi_{y}) or metal silicon nitride (MₓSi_{y}N_{z}) respectively included in the first middle layer 193A and the second middle layer 193B, the concentration of silicon (Si) may be about 1 wt% to about 20 wt%, but the disclosure is not limited thereto.

The second plate layer 195 may include the metal (M) included in the first middle layer 193A and the second middle layer 193B. In addition, the second plate layer 195 may be in a crystalline state. The thickness of the second plate layer 195 may be about 100 Å to about 1,000 Å, but is not limited thereto.

In the integrated circuit device 20 of the disclosure, the shape of the stacked plate structure 190A is described in detail as follows.

In one or more embodiments, the surface roughness of the first plate layer 191 at a surface in contact with the first middle layer 193A may be greater than the surface roughness of the second plate layer 195 at a surface in contact with the second middle layer 193B. That is, the first middle layer 193A may be formed to fill the relatively rough surface of the first plate layer 191, and the surface of the second plate layer 195 may be formed to be relatively smooth (see, e.g., FIG. 6 showing area CX2). Such a characteristic may be due to that each of the first middle layer 193A and the second middle layer 193B is in an amorphous state, and the first middle layer 193A and the second middle layer 193B include materials including both silicon (Si) included in the first plate layer 191 and the metal (M) included in the second plate layer 195.

In one or more embodiments, the sidewall of the first plate layer 191 may be completely covered with the first middle layer 193A, and most of the sidewall of the first middle layer 193A may be in contact with the second middle layer 193B, but a portion of the lower area of the sidewall of the first middle layer 193A may be in contact with the interlayer insulating film 210. In addition, most of the sidewall of the second middle layer 193B may be in contact with the second plate layer 195, but a portion of the lower area of the sidewall of the second middle layer 193B may be in contact with the interlayer insulating film 210.

In one or more embodiments, the thickness in the vertical direction Z of the portion of the second plate layer 195 formed on the upper surface of the second middle layer 193B, may be greater than the width in the first horizontal direction X of the portion of the second plate layer 195 formed on the sidewall of the second middle layer 193B.

Ultimately, the integrated circuit device 20 according to an embodiment may have improved electrical characteristics and product reliability by using the stacked plate structure 190A, in which the first middle layer 193A and the second middle layer 193B are inserted between the first plate layer 191 of a doped silicon germanium (SiGe) layer and the second plate layer 195 of a tungsten (W) plate layer, in the DRAM including the stacked plate structure 190A on the capacitor structure 180.

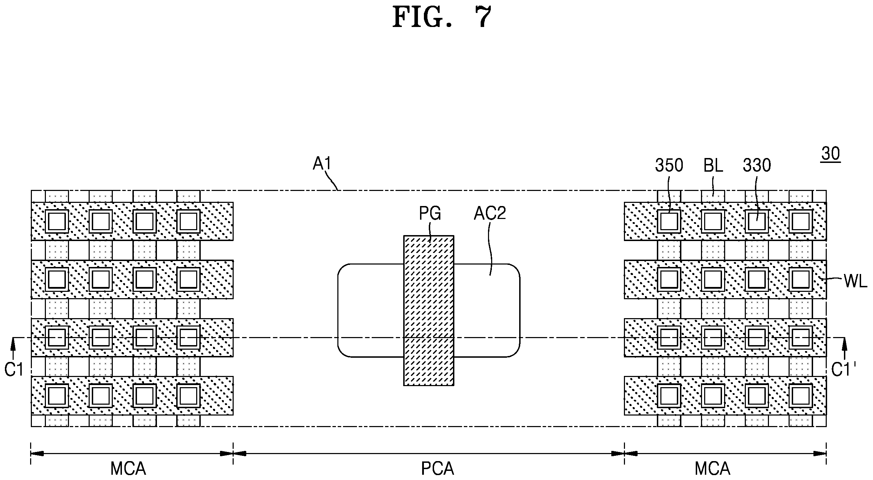

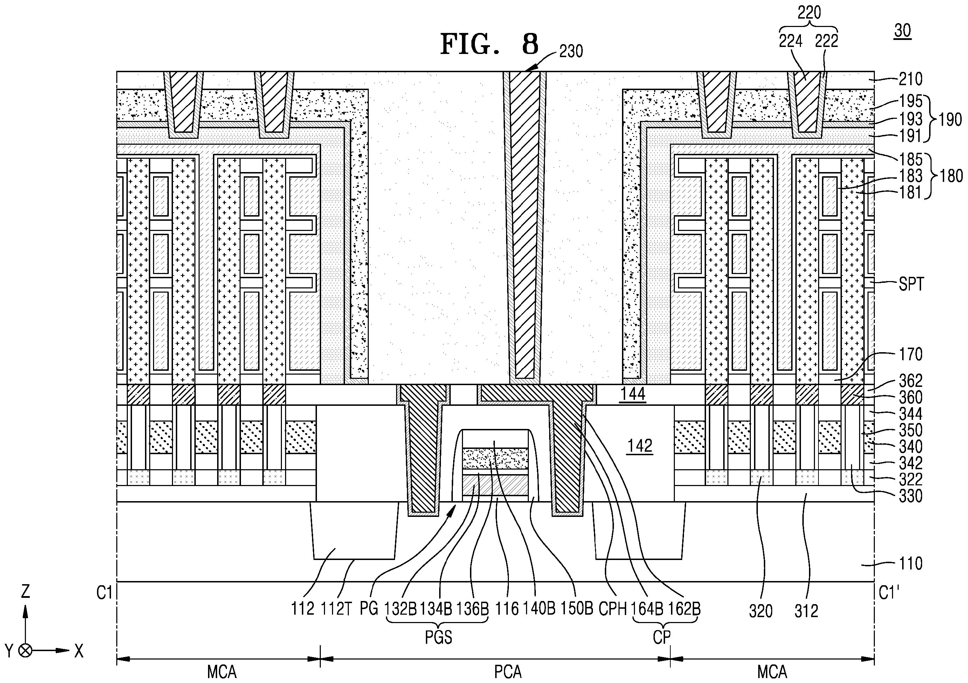

FIG. 7 is a layout diagram illustrating an integrated circuit device according to another embodiment, and FIG. 8 is a cross-sectional view of the integrated circuit device taken along a line C1-C1' of FIG. 7.

Hereinafter, most of the components constituting an integrated circuit device 30 as described below, and the materials of the components of same, are substantially the same as or similar to those described above with reference to FIGS. 1 to 4. Accordingly, for convenience of explanation, the following description focuses on differences between integrated circuit device 30 and integrated circuit device 10.

Referring to FIGS. 7 and 8 together, the integrated circuit device 30 may include a plurality of conductive lines 320, a channel layer 330, a gate electrode layer 340, a gate insulating layer 350, and the capacitor structure 180, which are arranged in the memory cell area MCA of the substrate 110.

The integrated circuit device 30 of the disclosure may be a memory device including a vertical channel transistor, and the vertical channel transistor may be referred to as a structure in which the channel length of the channel layer 330 extends from the substrate 110 in the vertical direction Z.

A lower insulating layer 312 may be arranged on the substrate 110, and the plurality of conductive lines 320 may be arranged on the lower insulating layer 312 to be spaced apart from each other in the first horizontal direction X and to extend in the second horizontal direction Y. A plurality of first insulating patterns 322 may be arranged on the lower insulating layer 312 to fill spaces between the plurality of conductive lines 320. The plurality of conductive lines 320 may respectively correspond to the bit lines BL of the integrated circuit device 30.

In one or more embodiments, the plurality of conductive lines 320 may include doped polysilicon, metal, conductive metal nitride, conductive metal silicide, conductive metal oxide, or a combination thereof. The plurality of conductive lines 320 may include a single layer or a multi-layer, each including the above materials. In other embodiments, the plurality of conductive lines 320 may include a two-dimensional material, and the two-dimensional material may include, for example, graphene, carbon nanotube, nanosheets, or a combination thereof.

The channel layers 330 may be arranged in island shapes on the plurality of conductive lines 320 to be spaced apart from each other in the first horizontal direction X and the second horizontal direction Y. The channel layer 330 may have a first width in the first horizontal direction X and a first height in the vertical direction Z, and the first height may be greater than the first width. The bottom portion of the channel layer 330 may function as a first source/drain area, the upper portion of the channel layer 330 may function as a second source/drain area, and a portion of the channel layer 330 between the first source/drain area and the second source/drain area may function as a channel area.

The gate electrode layer 340 may surround the sidewall of the channel layer 330 and extend in the first horizontal direction X. In a plan view, the gate electrode layer 340 may be a gate all-round type surrounding all sidewalls (for example, all four sidewalls) of the channel layer 330. The gate electrode layer 340 may correspond to a word line WL of the integrated circuit device 30.

In other embodiments, the gate electrode layer 340 may be a dual gate type and may include, for example, a first sub-gate electrode facing a first sidewall of the channel layer 330 and a second sub-gate electrode facing a second sidewall opposite to the first sidewall of the channel layer 330. In other embodiments, the gate electrode layer 340 may be a single gate type that covers only the first sidewall of the channel layer 330 and extends in the first horizontal direction X.

The gate electrode layer 340 may include doped polysilicon, metal, conductive metal nitride, conductive metal silicide, conductive metal oxide, or a combination thereof.

The gate insulating layer 350 may surround the sidewall of the channel layer 330 and may be arranged between the channel layer 330 and the gate electrode layer 340. In one or more embodiments, the gate insulating layer 350 may include silicon oxide, silicon nitride, a high dielectric material, or a combination thereof.

A first buried insulating layer 342 surrounding the lower sidewall of the channel layer 330 may be arranged on the plurality of first insulating patterns 322, and a second buried insulating layer 344 that surrounds the upper sidewall of the channel layer 330 and covers the gate electrode layer 340 may be arranged on the first buried insulating layer 342.

A capacitor contact 360 may be arranged above the channel layer 330. The capacitor contact 360 may be arranged to overlap the channel layer 330 in the vertical direction Z and may be arranged in a matrix form to be spaced apart from each other in the first horizontal direction X and the second horizontal direction Y. An upper insulating layer 362 may be arranged on the second buried insulating layer 344 to surround the sidewall of the capacitor contact 360.

In the integrated circuit device 30 of the disclosure, the upper insulating pattern 170 may be arranged on the upper insulating layer 362, and the capacitor structure 180 may be arranged on the upper insulating pattern 170. In addition, the stacked plate structure 190 may be arranged along the surface of the capacitor structure 180. Herein, the stacked plate structure 190 may include the first plate layer 191, the middle layer 193 conformally covering the first plate layer 191, and the second plate layer 195 conformally covering the middle layer 193.

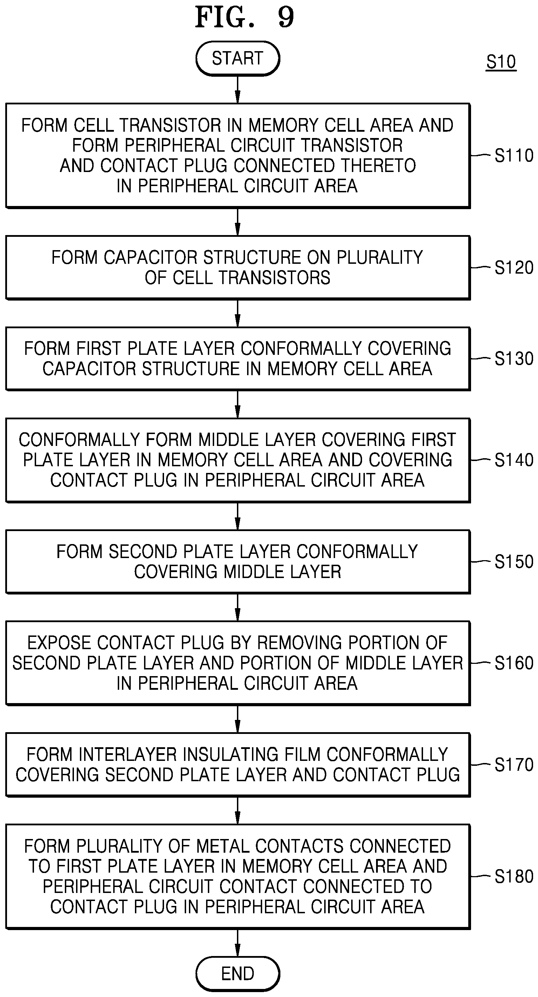

FIG. 9 is a flowchart illustrating a method of manufacturing an integrated circuit device, according to an embodiment.

Referring to FIG. 9, a method S10 of manufacturing an integrated circuit device may include process orders of first to eighth operations S110 to S180.

When a certain embodiment may be implemented differently, a specific process order may be performed differently from the described order. For example, two consecutively described processes may be performed substantially at the same time or performed in an order opposite to the described order.

The method S10 of manufacturing an integrated circuit device according to the disclosure may include first operation S 110 of forming a cell transistor in a memory cell area and forming a peripheral circuit transistor and a contact plug connected to the peripheral circuit transistor in a peripheral circuit area, second operation S120 of forming a capacitor structure on the plurality of cell transistors, third operation S130 of forming a first plate layer conformally covering the capacitor structure in the memory cell area, fourth operation S140 of conformally forming a middle layer covering the first plate layer in the memory cell area and covering the contact plug in the peripheral circuit area, fifth operation S 150 of forming a second plate layer conformally covering the middle layer, sixth operation S160 of exposing the contact plug by removing a portion of the second plate layer and a portion of the middle layer in the peripheral circuit area, seventh operation S170 of an interlayer insulating film conformally covering the second plate layer and the contact plug, and eighth operation S 180 of forming a plurality of metal contacts connected to the first plate layer in the memory cell area and a peripheral circuit contact connected to the contact plug in the peripheral circuit area.

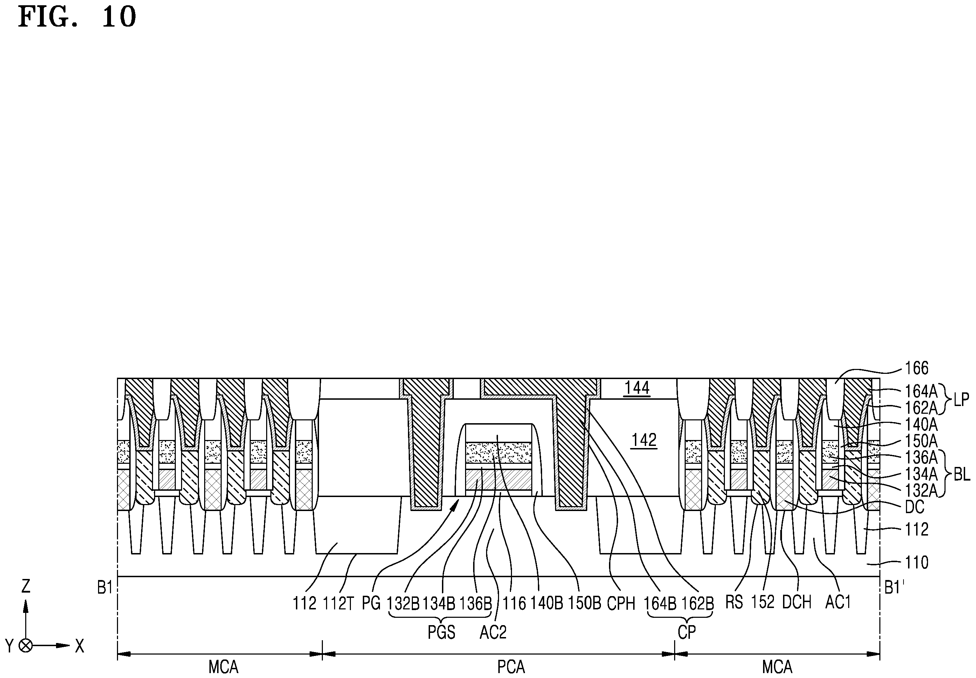

Technical features of each of first to eighth operations S110 to S180 are described below in detail with reference to FIGS. 10 to 19 below.

FIGS. 10 to 19 are cross-sectional views illustrating a method of manufacturing an integrated circuit device according to an embodiment in a process order.

Referring FIG. 10, a plurality of device isolation trenches 112T and a plurality of device isolation films 112 may be formed in the substrate 110 having the memory cell area MCA and the peripheral circuit area PCA.

Through the plurality of device isolation films 112, the plurality of first active areas AC1 may be defined in the memory cell area MCA of the substrate 110, and the second active area AC2 may be defined in the peripheral circuit area PCA of the substrate 110. Next, the gate dielectric film 116 may be formed on the substrate 110 in the peripheral circuit area PCA.

Then, the direct contact hole DCH exposing the first active area AC1 may be formed by removing a portion of the substrate 110, and the direct contact DC may be formed within the direct contact hole DCH. Next, a bit line BL and an insulating capping layer 140A may be formed on the direct contact DC, and the gate electrode PGS and the gate capping pattern 140B may be formed on the gate dielectric film 116. Then, a gate spacer 150B may be formed on the sidewall of the gate electrode PGS, and the first insulating film 142 covering the gate electrode PGS may be formed.

Next, a spacer 150A may be formed on the bit line BL and the insulating capping layer 140A in the memory cell area MCA, and a plurality of insulating fences may be formed between the plurality of bit lines BL. Then, a portion of the substrate 110, which is arranged at the bottom of a contact space between the plurality of bit lines BL and the plurality of insulating fences, may be removed to form a plurality of recess spaces RS, which expose the first active area AC1, between the plurality of bit lines BL. Next, the plurality of conductive plugs 152 filling a portion of the contact space between the plurality of bit lines BL while filling the plurality of recess spaces RS may be formed.

Then, a plurality of contact holes CPH exposing the second active area AC2 may be formed by etching the first insulating film 142 in the peripheral circuit area PCA.

Next, the plurality of landing pads LP each including the conductive barrier film 162A and the landing pad conductive layer 164A may be formed in the memory cell area MCA, and a plurality of contact plugs CP each including the conductive barrier film 162B and the landing pad conductive layer 164B may be formed in the peripheral circuit area PCA. Then, the insulating pattern 166 surrounding the sidewalls of the plurality of landing pads LP and the second insulating film 144 covering the sidewall of the contact plug CP may be formed.

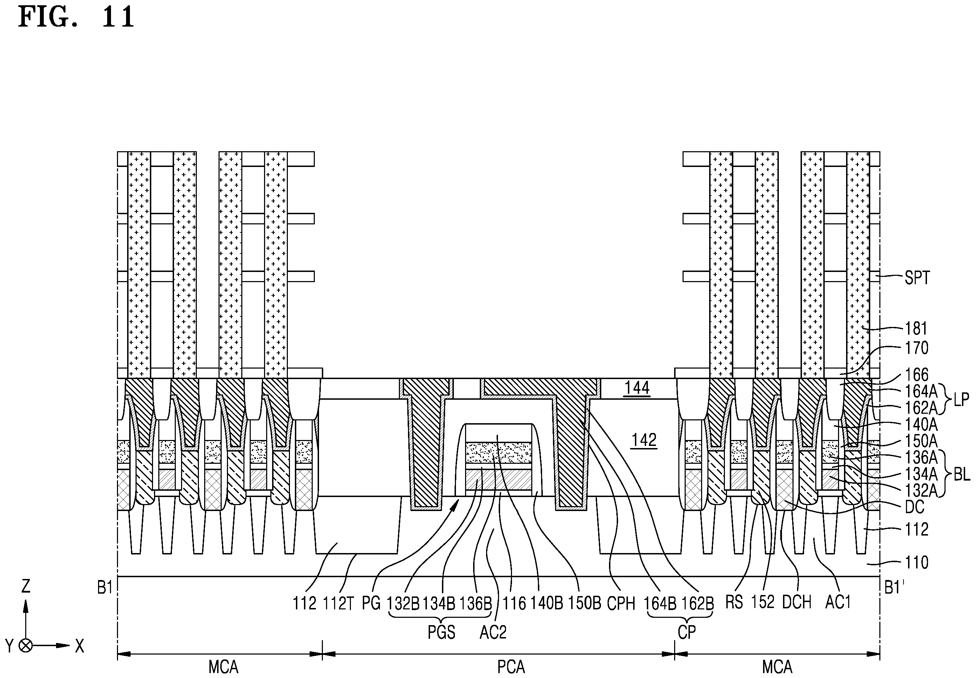

Referring to FIG. 11, in the memory cell area MCA, a mold structure including a plurality of mold layers sequentially arranged on the upper insulating pattern 170 may be formed.

The support layer SPT may be selectively formed between the plurality of mold layers and on the plurality of mold layers.

Then, a mask pattern may be formed on the mold structure, an opening portion penetrating the mold structure may be formed by using the mask pattern as an etch mask, and the lower electrode 181 may be formed in the opening portion.

Next, the upper insulating pattern 170, the lower electrode 181, and the support layer SPT may be formed by removing the mold structure.

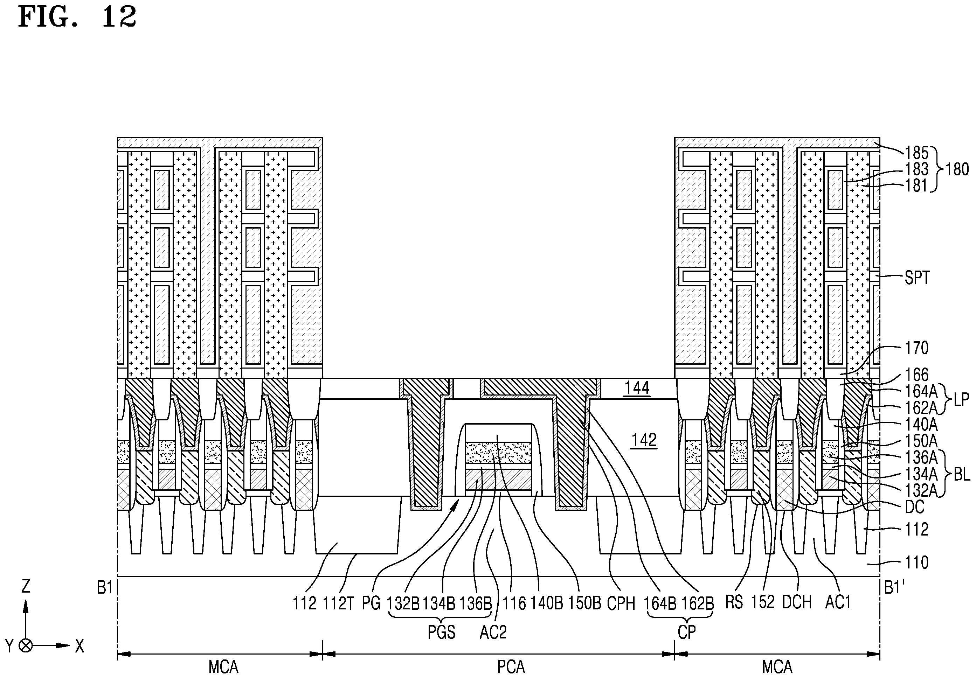

Referring to FIG. 12, the capacitor dielectric film 183 may be formed on the upper insulating pattern 170, the lower electrode 181, and the support layer SPT.

In particular, the capacitor dielectric film 183 may be formed on the plurality of lower electrodes 181 in the memory cell area MCA. The capacitor dielectric film 183 may extend from the sidewalls of the plurality of lower electrodes 181 to the upper surface and the bottom surface of the support layer SPT and may extend onto the upper insulating pattern 170.

Then, the upper electrode 185 may be formed on the capacitor dielectric film 183. The upper electrode 185 may be formed to entirely cover the capacitor dielectric film 183 and may be formed to cover the plurality of lower electrodes 181 with the capacitor dielectric film 183 therebetween.

In this way, the capacitor structure 180 including the lower electrode 181, the capacitor dielectric film 183, and the upper electrode 185 may be formed.

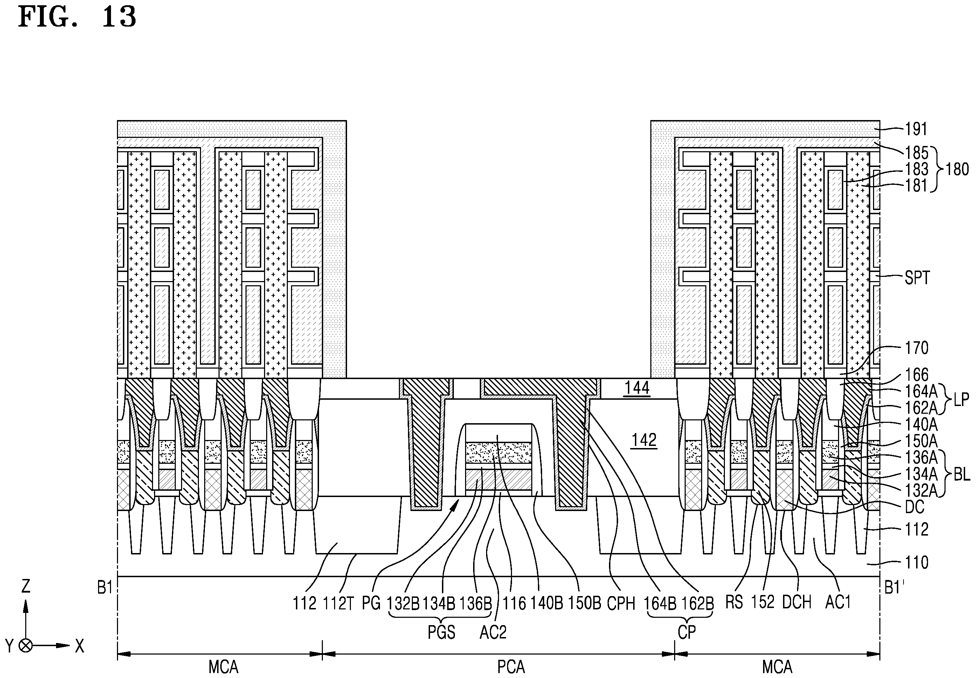

Referring to FIG. 13, the first plate layer 191 may be formed in the memory cell area MCA to cover the capacitor structure 180.

The first plate layer 191 may be formed by doping silicon germanium (SiGe) with a p-type impurity. The p-type impurity may be, for example, boron (B), gallium (Ga), indium (In), or the like. In addition, the first plate layer 191 may be in a crystalline state. The thickness of the first plate layer 191 may be about 800 Å to about 2,000 Å, but is not limited thereto.

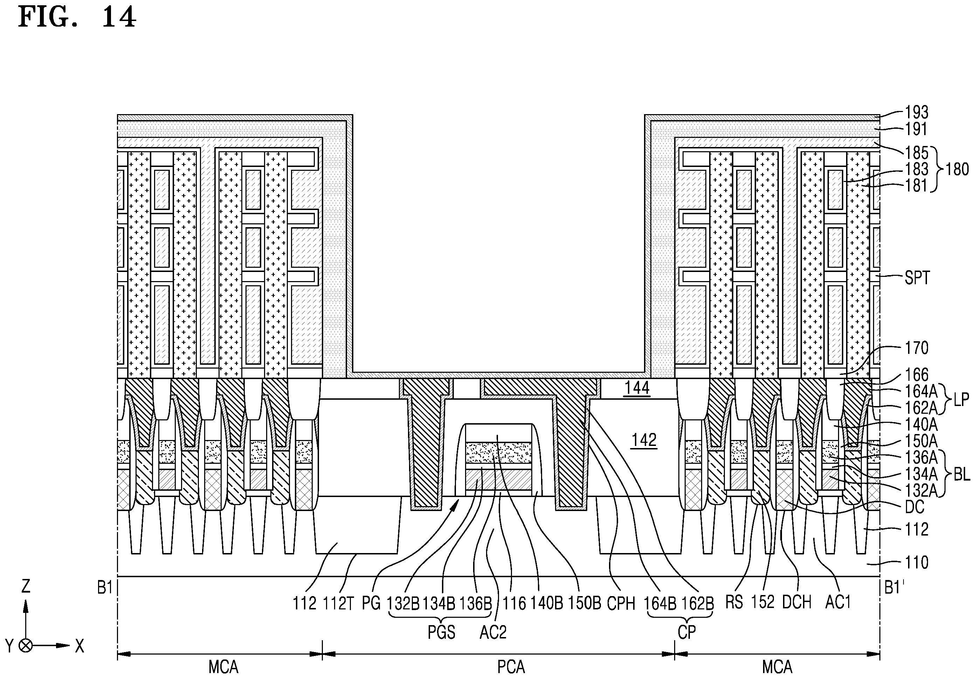

Referring to FIG. 14, the middle layer 193 covering the first plate layer 191 in the memory cell area MCA and covering the contact plug CP in the peripheral circuit area PCA may be conformally formed.

The middle layer 193 may include metal silicide (MₓSi_{y}) or metal silicon nitride (MₓSi_{y}N_{z}). In one or more embodiments, the metal (M) may be tungsten (W). In this case, the middle layer 193 may include one selected from tungsten silicide (WSiₓ) and tungsten silicon nitride (WSiₓN_{y}). When the middle layer 193 includes tungsten silicon nitride (WSiₓN_{y}), the nitrogen (N) may be included in the middle layer 193 through a plasma nitridation process.

Herein, the middle layer 193 may be in an amorphous state, or the middle layer 193 may be configured to have an amorphous state in most (over 50 %) of the areas thereof and a crystallized state only in local areas thereof. The thickness of the middle layer 193 may be about 50 Å to about 200 Å, but is not limited thereto.

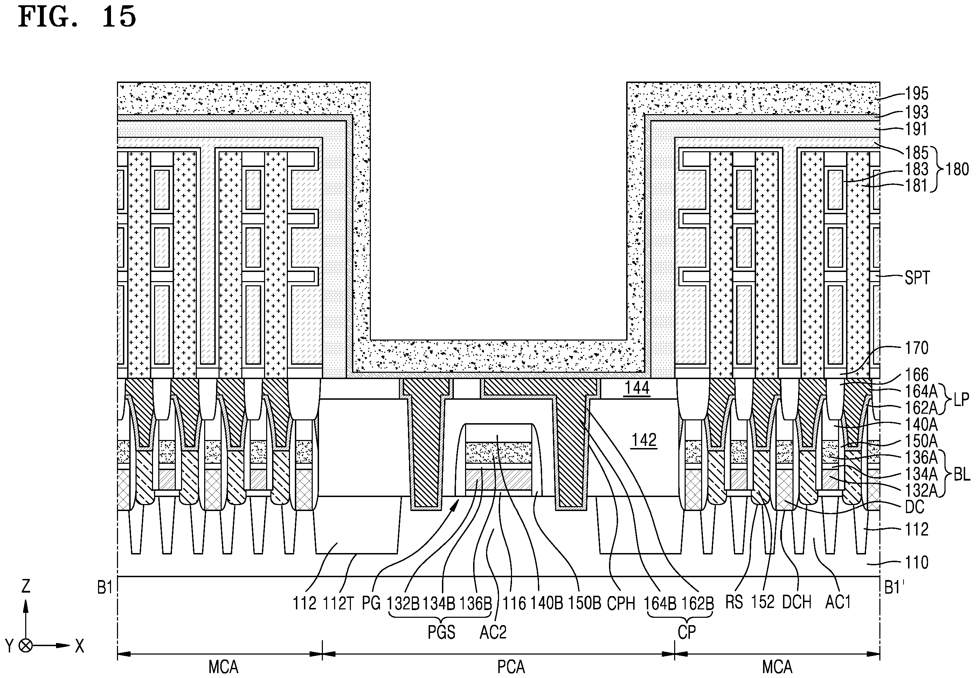

Referring to FIG. 15, the second plate layer 195 may be formed to conformally cover the middle layer 193.

The second plate layer 195 may be formed to include the metal (M) included in the middle layer 193. In one or more embodiments, the metal (M) may be tungsten (W). In addition, the second plate layer 195 may be formed to have a crystalline state. The thickness of the second plate layer 195 may be formed from about 100 Å to about 1,000 Å, but is not limited thereto.

In one or more embodiments, the thickness in the vertical direction Z of the portion of the second plate layer 195 formed on the upper surface of the middle layer 193, may be greater than the width in the first horizontal direction X of the portion of the second plate layer 195 formed on the sidewall of the middle layer 193. Such a characteristic may be due to that the formation method of the second plate layer 195 is a PVD process.

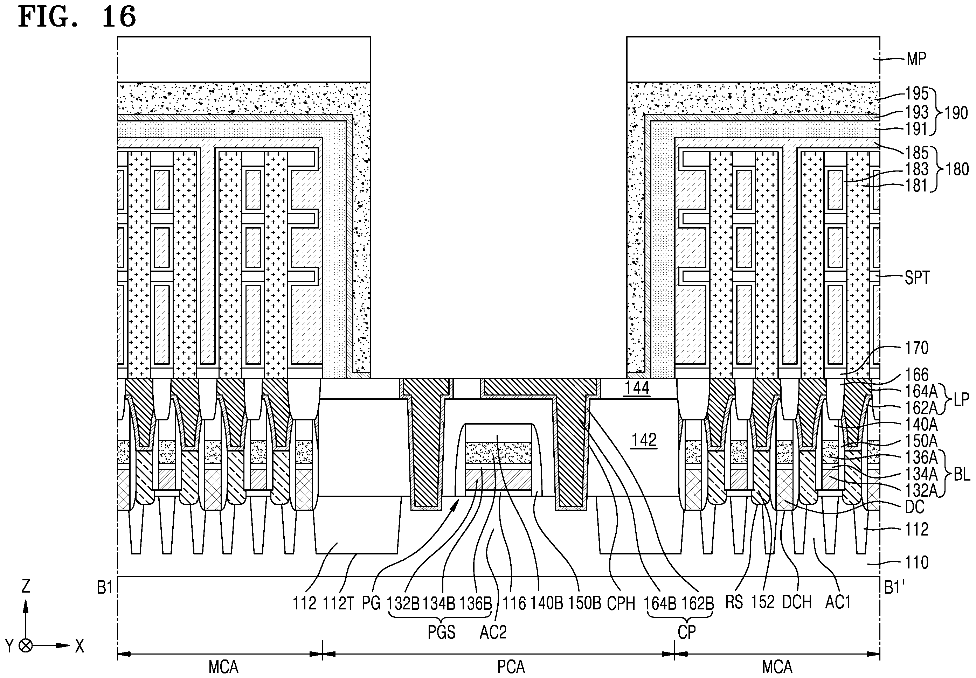

Referring to FIG. 16, a contact pad of each of the plurality of contact plugs CP may be exposed by etching a portion of the middle layer 193 and the second plate layer 195 in the peripheral circuit area PCA by using a mask pattern MP as an etch mask.

The etching may be a dry etching process. The dry etching process may be performed as a process of etching a portion of the middle layer 193 and the second plate layer 195 in the peripheral circuit area PCA but reducing the etching of the plurality of contact plugs CP and the second insulating film 144.

In particular, the outermost sidewall of the middle layer 193, the outermost sidewall of the second plate layer 195, and the outermost sidewall of the mask pattern MP may be coplanar in the vertical direction Z. After the dry etching process, the mask pattern MP may be removed in an ashing and strip process.

Accordingly, the sidewall of the first plate layer 191 may be completely covered with the middle layer 193, and most of the sidewall of the middle layer 193 may be in contact with the second plate layer 195, but a portion of the lower area of the sidewall of the middle layer 193 may be exposed to the outside. Such a characteristic may be due to a manufacturing process in which a portion of the middle layer 193 and a portion of the second plate layer 195 are dry-etched together.

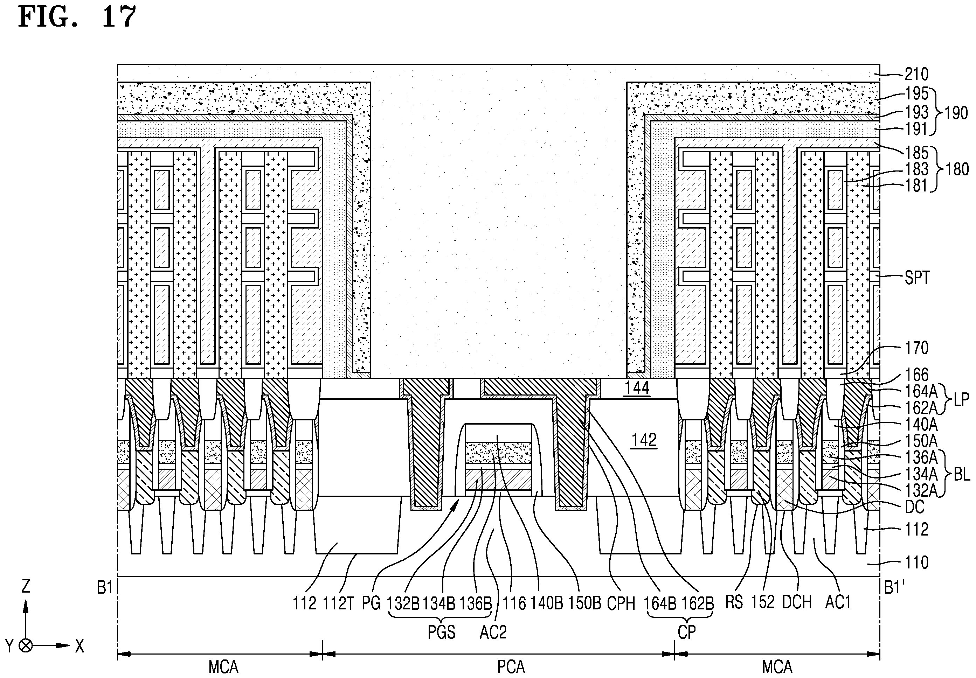

Referring to FIG. 17, the interlayer insulating film 210 conformally covering the middle layer 193, the second plate layer 195, and the plurality of contact plugs CP may be formed.

The interlayer insulating film 210 may be formed to cover both the memory cell area MCA and the peripheral circuit area PCA. The interlayer insulating film 210 may have an uppermost surface level that is the same in each of the memory cell area and the peripheral circuit area PCA. In particular, the interlayer insulating film 210 may have different thicknesses in the vertical direction Z in respective areas to cover a step-difference depending on the presence or absence of the capacitor structure 180 and the stacked plate structure 190 in the memory cell area MCA and the peripheral circuit area PCA.

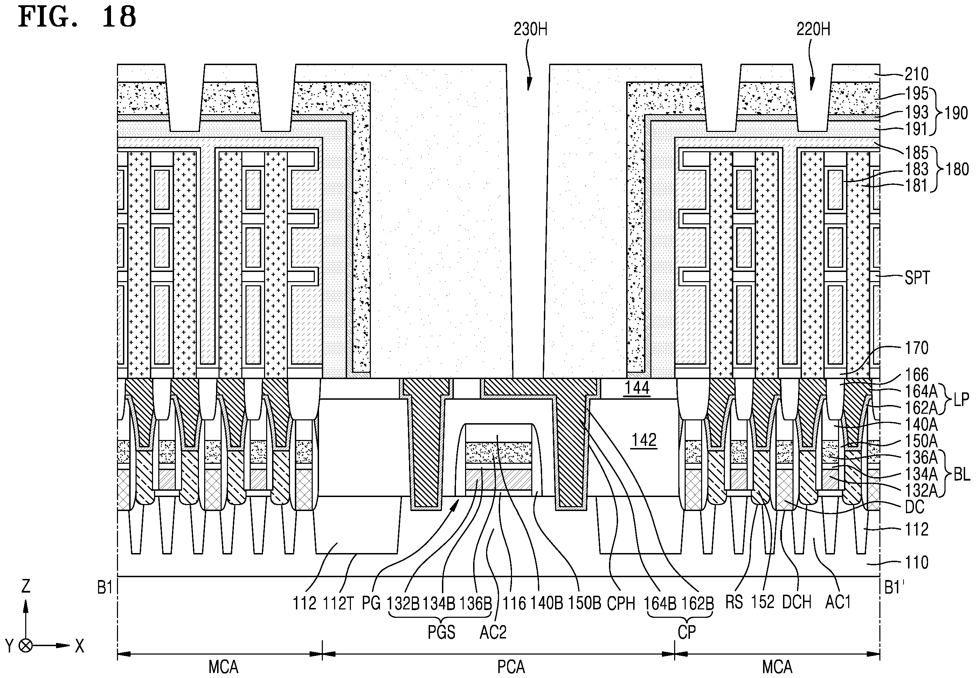

Referring to FIG. 18, a plurality of metal contact holes 220H penetrating the interlayer insulating film 210 may be formed in the memory cell area MCA, and a peripheral circuit contact hole 230H penetrating the interlayer insulating film 210 may be formed in the peripheral circuit area PCA.

In particular, the plurality of metal contact holes 220H may expose the inside of the first plate layer 191 by penetrating the interlayer insulating film 210, the second plate layer 195, and the middle layer 193. The peripheral circuit contact hole 230H may expose the uppermost surface of a contact pad of the contact plug CP by penetrating the interlayer insulating film 210.

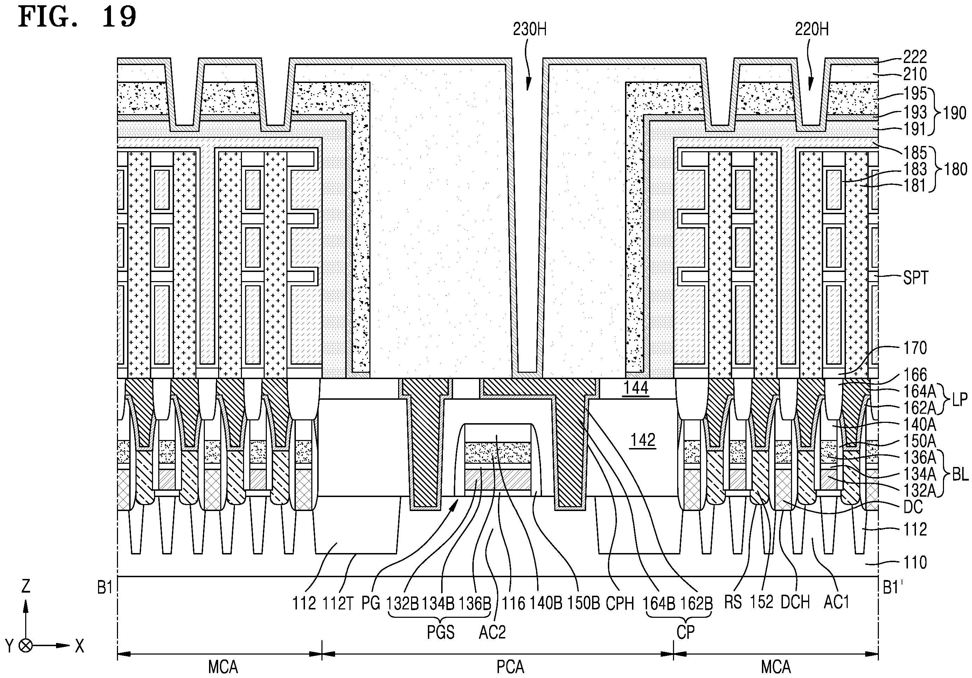

Referring to FIG. 19, the conductive barrier film 222 conformally covering the inner sidewalls of the plurality of metal contact holes 220H and the inner sidewall of the peripheral circuit contact hole 230H may be formed.

In particular, the conductive barrier film 222 may be continuously and conformally formed across the memory cell area MCA and the peripheral circuit area PCA. The conductive barrier film 222 may include Ti, TiN, or a combination thereof, but is not limited thereto.

Referring to FIG. 3 again, the contact conductive layer 224 filling the plurality of metal contact holes 220H and the peripheral circuit contact hole 230H may be formed, and the upper portion of the contact conductive layer 224 and the upper portion of the conductive barrier film 222 may be polished to form the plurality of metal contacts 220 and the peripheral circuit contact 230.

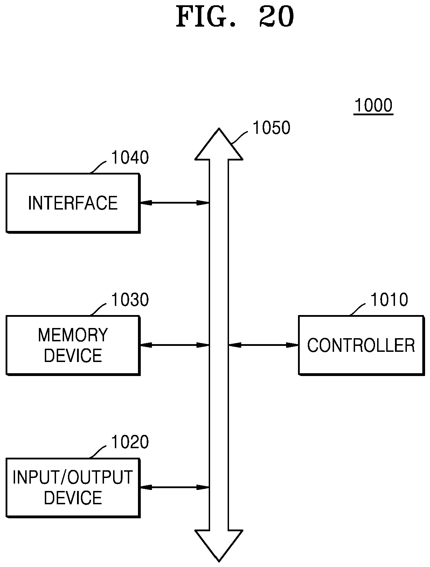

FIG. 20 is a configuration diagram illustrating a system including an integrated circuit device according to an embodiment.

Referring to FIG. 20, a system 1000 may include a controller 1010, an input/output device 1020, a memory device 1030, an interface 1040, and a bus 1050.

The system 1000 may be a mobile system or a system that transmits or receives information. In one or more embodiments, the mobile system may be a portable computer, a web tablet, a mobile phone, a digital music player, or a memory card.

The controller 1010 is configured to control an execution program in the system 1000 and may include a microprocessor, a digital signal processor, a microcontroller, or a similar device.

The input/output device 1020 may be used to input or output data of the system 1000. The system 1000 may be connected to an external device, for example, a personal computer or a network, by using the input/output device 1020, and may exchange data with the external device. The input/output device 1020 may be, for example, a touch screen, a touchpad, a keyboard, or a display device.

The memory device 1030 may store data for the operation of the controller 1010 or store data processed by the controller 1010. The memory device 1030 may include any one of the integrated circuit devices 10, 20, and 30 according to the embodiments described above.

The interface 1040 may be a data transmission path between the system 1000 and an external device. The controller 1010, the input/output device 1020, the memory device 1030, and the interface 1040 may communicate with each other through the bus 1050.

While the disclosure has been particularly shown and described with reference to embodiments thereof, it will be understood that various changes in form and details may be made therein without departing from the scope of the following claims.

Further Embodiments are set out in the following clauses:
Clause 1. An integrated circuit device comprising:
   a substrate comprising a memory cell area and a peripheral circuit area around the memory cell area;
   a cell transistor in the memory cell area;
   a peripheral circuit transistor in the peripheral circuit area;
   a capacitor structure comprising a lower electrode on the cell transistor, a dielectric film on a surface of the lower electrode, and an upper electrode on the dielectric film;
   a stacked plate structure covering the capacitor structure; and
   an interlayer insulating film covering the stacked plate structure in the memory cell area and covering the peripheral circuit transistor in the peripheral circuit area,
   wherein the stacked plate structure comprises:
      a first plate layer comprising doped silicon germanium (SiGe);
      a middle layer conformally covering the first plate layer and comprising a metal silicide (MₓSi_{y}) comprising a metal (M); and
      a second plate layer conformally covering the middle layer and comprising the metal (M) of the metal silicide.
Clause 2. The integrated circuit device of clause 1,
   wherein at least a portion of the middle layer is in an amorphous state, and
   wherein each of the first plate layer and the second plate layer are in a crystalline state.
Clause 3. The integrated circuit device of clause 1 or clause 2, wherein a thickness of the first plate layer is about 800 Å to about 2,000 Å, a thickness of the middle layer is about 50 Å to about 200 Å, and a thickness of the second plate layer is about 100 Å to about 1,000 Å.
Clause 4. The integrated circuit device of any preceding clause, wherein the metal silicide (MₓSi_{y}) comprises a concentration of silicon (Si) in a range from about 1 wt% to about 20 wt%.
Clause 5. The integrated circuit device of any preceding clause,
   wherein the first plate layer is doped with a p-type impurity, and
   wherein the metal (M) comprises tungsten (W).
Clause 6. The integrated circuit device of any preceding clause, wherein a surface roughness of a surface of the first plate layer in contact with the middle layer is greater than a surface roughness of a surface of the second plate layer in contact with the middle layer.
Clause 7. The integrated circuit device of any preceding clause,
   wherein a sidewall of the first plate layer is completely covered by the middle layer,
   wherein a portion of a sidewall of the middle layer is in contact with the second plate layer, and
   wherein the sidewall of the middle layer excluding the portion in contact with the second plate layer is in contact with the interlayer insulating film.
Clause 8. The integrated circuit device of any preceding clause, wherein a vertical thickness of a first portion of the second plate layer formed on an upper surface of the middle layer is greater than a horizontal width of a second portion of the second plate layer formed on a sidewall of the middle layer.
Clause 9. The integrated circuit device of any preceding clause, further comprising:
   a metal contact connected to the stacked plate structure and penetrating the interlayer insulating film in the memory cell area; and
   a peripheral circuit contact connected to the peripheral circuit transistor and penetrating the interlayer insulating film in the peripheral circuit area.
Clause 10. The integrated circuit device of clause 9,
   wherein the metal contact sequentially penetrates the second plate layer and the middle layer,
   wherein a level of a lowermost surface of the metal contact is lower than a level of an uppermost surface of the first plate layer and is higher than a level of an uppermost surface of the upper electrode, and
   wherein a level of a lowermost surface of the peripheral circuit contact is substantially the same as a level of a lowermost surface of the first plate layer and a level of a lowermost surface of the middle layer and is lower than a level of a lowermost surface of the second plate layer.

## Claims

1. An integrated circuit device comprising:
a substrate comprising a memory cell area and a peripheral circuit area around the memory cell area;
a cell transistor in the memory cell area;
a peripheral circuit transistor in the peripheral circuit area;
a capacitor structure comprising a lower electrode on the cell transistor, a dielectric film on a surface of the lower electrode, and an upper electrode on the dielectric film;
a stacked plate structure covering the capacitor structure; and
an interlayer insulating film covering the stacked plate structure in the memory cell area and covering the peripheral circuit transistor in the peripheral circuit area,
wherein the stacked plate structure comprises:
a first plate layer comprising doped silicon germanium (SiGe);
a middle layer conformally covering the first plate layer, the middle layer comprising a metal silicide (MₓSi_{y}) comprising a metal (M) or the middle layer comprising a metal silicon nitride (MₓSi_{y}N) comprising a metal (M); and
a second plate layer conformally covering the middle layer and comprising the metal (M) included in the middle layer.

2. The integrated circuit device of claim 1,
wherein at least a portion of the middle layer is in an amorphous state, and
wherein each of the first plate layer and the second plate layer are in a crystalline state.

3. The integrated circuit device of claim 1 or claim 2, wherein a thickness of the first plate layer is about 800 Å to about 2,000 Å, a thickness of the middle layer is about 50 Å to about 200 Å, and a thickness of the second plate layer is about 100 Å to about 1,000 Å.

4. The integrated circuit device of any preceding claim, wherein the metal silicide (MₓSi_{y}) or metal silicon nitride (MₓSi_{y}N) comprises a concentration of silicon (Si) in a range from about 1 wt% to about 20 wt%.

5. The integrated circuit device of any preceding claim,
wherein the first plate layer is doped with a p-type impurity, and
wherein the metal (M) comprises tungsten (W).

6. The integrated circuit device of any preceding claim, wherein a surface roughness of a surface of the first plate layer in contact with the middle layer is greater than a surface roughness of a surface of the second plate layer in contact with the middle layer.

7. The integrated circuit device of any preceding claim,
wherein a sidewall of the first plate layer is completely covered by the middle layer,
wherein a portion of a sidewall of the middle layer is in contact with the second plate layer, and
wherein the sidewall of the middle layer excluding the portion in contact with the second plate layer is in contact with the interlayer insulating film.

8. The integrated circuit device of any preceding claim, wherein a vertical thickness of a first portion of the second plate layer formed on an upper surface of the middle layer is greater than a horizontal width of a second portion of the second plate layer formed on a sidewall of the middle layer.

9. The integrated circuit device of any preceding claim, further comprising:
a metal contact connected to the stacked plate structure and penetrating the interlayer insulating film in the memory cell area; and
a peripheral circuit contact connected to the peripheral circuit transistor and penetrating the interlayer insulating film in the peripheral circuit area.

10. The integrated circuit device of claim 9,
wherein the metal contact sequentially penetrates the second plate layer and the middle layer,
wherein a level of a lowermost surface of the metal contact is lower than a level of an uppermost surface of the first plate layer and is higher than a level of an uppermost surface of the upper electrode, and
wherein a level of a lowermost surface of the peripheral circuit contact is substantially the same as a level of a lowermost surface of the first plate layer and a level of a lowermost surface of the middle layer and is lower than a level of a lowermost surface of the second plate layer.

11. An integrated circuit device comprising:
a substrate comprising a memory cell area and a peripheral circuit area around the memory cell area;
a cell transistor in the memory cell area;
a peripheral circuit transistor in the peripheral circuit area;
a capacitor structure comprising a lower electrode on the cell transistor, a dielectric film on a surface of the lower electrode, and an upper electrode on the dielectric film;
a stacked plate structure covering the capacitor structure; and
an interlayer insulating film covering the stacked plate structure in the memory cell area and covering the peripheral circuit transistor in the peripheral circuit area,
wherein the stacked plate structure comprises:
a first plate layer comprising doped silicon germanium (SiGe);
a second plate layer comprising a metal (M); and
a first middle layer comprising a metal silicide (MₓSi_{y}) and a second middle layer comprising a metal silicon nitride (MₓSi_{y}N), wherein the first middle layer and the second middle layer are between the first plate layer and the second plate layer.

12. The integrated circuit device of claim 11,
wherein each of the first plate layer and the second plate layer is in a crystalline state, and
wherein at least a portion of each of the first middle layer and the second middle layer is in an amorphous state.

13. The integrated circuit device of claim 11 or claim 12, wherein a thickness of the first middle layer is less than a thickness of the second middle layer.

14. The integrated circuit device of any one of claims 11 - 13, wherein the first plate layer is in direct contact with the first middle layer, and the second plate layer is in direct contact with the second middle layer.

15. The integrated circuit device of any one of claims 11 - 14, wherein the first plate layer is in direct contact with the second middle layer, and the second plate layer is in direct contact with the first middle layer.
